(19) Europäisches Patentamt
European Patent Office
Office européen des brevets

(11) **EP 4 618 080 A1**

(12) **EUROPEAN PATENT APPLICATION**
published in accordance with Art. 153(4) EPC

(43) Date of publication:
**17.09.2025 Bulletin 2025/38**

(21) Application number: **24757056.7**

(22) Date of filing: **24.01.2024**

(51) International Patent Classification (IPC):
**G10L 21/0272** (2013.01)   **G10L 21/0208** (2013.01)
**G10L 25/18** (2013.01)   **G10L 25/24** (2013.01)
**G10L 25/81** (2013.01)   **G10L 21/0332** (2013.01)

(52) Cooperative Patent Classification (CPC):
**G10L 21/0208; G10L 21/0272; G10L 21/0332;
G10L 25/18; G10L 25/24; G10L 25/81**

(86) International application number:
**PCT/KR2024/001134**

(87) International publication number:
**WO 2024/172326 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **14.02.2023  KR 20230019599
26.05.2023  KR 20230068617**

(71) Applicant: **Samsung Electronics Co., Ltd.
Suwon-si, Gyeonggi-do 16677 (KR)**

(72) Inventors:
• **EOM, Deokjun
Suwon-si, Gyeonggi-do 16677 (KR)**
• **KIM, Kyungrae
Suwon-si, Gyeonggi-do 16677 (KR)**
• **NAM, Woohyun
Suwon-si, Gyeonggi-do 16677 (KR)**
• **KIM, Jungkyu
Suwon-si, Gyeonggi-do 16677 (KR)**

(74) Representative: **Appleyard Lees IP LLP
15 Clare Road
Halifax HX1 2HY (GB)**

(54) **AUDIO SEPARATION METHOD AND ELECTRONIC DEVICE FOR PERFORMING SAME**

(57)     Provided is a method for separating one or more candidate audios in a sound source including the one or more candidate audios and a background sound, by using an audio separation system, the method including extracting a first audio feature from the sound source, extracting a background sound feature from the sound source, the background sound feature identifying a degree of association between the first audio feature and the background sound, generating a second audio feature based on the first audio feature, the background sound feature, and a background sound control parameter configured to control the background sound and generating one or more separated audios based on target information corresponding to the one or more candidate audios, the first audio feature, and the second audio feature in which the background sound is adjusted.

FIG. 2

EP 4 618 080 A1

**Description**

[Technical Field]

The disclosure relates to a method of audio processing, and an electronic device for performing the method. In particular, the disclosure relates to a method of performing audio separation on a sound source, and an electronic device for performing the method.

[Background Art]

Audio separation technology is a technology in which one or more candidate audio from a sound source are separated. For example, in general, audio features are extracted from a sound source by using a convolution block, a spectrogram corresponding to each candidate audio is generated from the audio features by using an up-convolution block, and a final separated audio is obtained. In this process, target information corresponding to each candidate audio is required, and in general, visual information (e.g., an image containing all or part of the face of a speaker corresponding to a candidate audio) or audio information (e.g., a pre-recorded voice of a speaker corresponding to a candidate audio) is used as target information.

Related art audio separation technologies focus on only extraction of features of a candidate audio, without considering a background sound included in a sound source, and thus have an issue that a background sound is included in a separated audio. In this case, in order to adjust the background sound (e.g., reduce the volume of the background sound or remove the background sound) in the separated audio, a separate model for extracting background sound characteristics is required. However, because two inferences are performed in a process of separating a candidate audio, from a sound source, and then removing a background sound from the separated audio, artificial sounds (e.g., artifacts) may be mixed into a final separated audio, and thus, an abnormal or unclear audio may be generated.

[Disclosure]

[Technical Solution]

According to an aspect of the disclosure, there is provided a method for separating one or more candidate audios in a sound source including the one or more candidate audios and a background sound, by using an audio separation system, the method including extracting a first audio feature from the sound source, extracting a background sound feature from the sound source, the background sound feature identifying a degree of association between the first audio feature and the background sound, generating a second audio feature based on the first audio feature, the background sound feature, and a background sound control parameter configured to control the background sound and generating one or more separated audios based on target information corresponding to the one or more candidate audios, the first audio feature, and the second audio feature in which the background sound is adjusted.

According to another aspect of the disclosure, there is provided a computer-readable recording medium having recorded thereon a computer program that, when executed by one or more computing devices, causing the one or more computing devices to perform a method of separating, by using an audio separation system, one or more candidate audios in a sound source including the one or more candidate audios and a background sound, the method including: extracting a first audio feature from the sound source, extracting a background sound feature from the sound source, the background sound feature identifying a degree of association between the first audio feature and the background sound, generating a second audio feature based on the first audio feature, the background sound feature, and a background sound control parameter configured to control the background sound and generating one or more separated audios based on target information corresponding to the one or more candidate audios, the first audio feature, and the second audio feature in which the background sound is adjusted.

According to another aspect of the disclosure, there is provided an electronic device including one or more processors and a memory storing a program for separating, by using an audio separation system one or more candidate audios in a sound source comprising the one or more candidate audios and a background sound. The program, when executed by the one or more processors, may cause the electronic device to perform operations including: extracting a first audio feature from the sound source, extracting a background sound feature from the sound source, the background sound feature identifying a degree of association between the first audio feature and the background sound, generating a second audio feature based on the first audio feature, the background sound feature, and a background sound control parameter configured to control the background sound and generating one or more separated audios based on target information corresponding to the one or more candidate audios, the first audio feature, and the second audio feature in which the background sound is adjusted.

[Description of Drawings]

   FIG. 1 is a diagram for describing a situation to which an audio separation method may be applied, according to an embodiment of the disclosure.
   FIG. 2 illustrates an audio separation system according to an embodiment of the disclosure.
   FIG. 3a is a diagram for describing an operation of a background sound feature control module according to an embodiment of the disclosure.

FIG. 3b shows an example of a background sound control function.

FIG. 4 is a diagram for describing a method of training an audio separation system, according to an embodiment of the disclosure.

FIG. 5 illustrates an audio separation system according to an embodiment of the disclosure.

FIG. 6 is a diagram for describing an operation of a background sound feature control module according to an embodiment of the disclosure.

FIG. 7 is a flowchart of an audio separation method according to an embodiment of the disclosure.

FIG. 8 is a block diagram schematically illustrating a configuration of an electronic device for performing an audio separation method, according to an embodiment of the disclosure.

FIG. 9a is a diagram for describing an application example of an audio separation system according to an embodiment of the disclosure.

FIG. 9b is a diagram for describing an application example of an audio separation system according to an embodiment of the disclosure.

FIG. 10a is a diagram for describing an application example of an audio separation system according to an embodiment of the disclosure.

FIG. 10b is a diagram for describing an application example of an audio separation system according to an embodiment of the disclosure.

FIG. 10c is a diagram for describing an application example of an audio separation system according to an embodiment of the disclosure.

[Mode for Invention]

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

As used herein, the expression "at least one of a, b, or c" may indicate only a, only b, only c, both a and b, both a and c, both b and c, all of a, b, and c, or variations thereof.

Although the terms used herein are selected from among common terms that are currently widely used in consideration of their functions in an embodiment of the disclosure, the terms may be different according to an intention of one of ordinary skill in the art, a precedent, or the advent of new technology. Also, in particular cases, the terms are discretionally selected by the applicant of the disclosure, in which case, the meaning of those terms will be described in detail in the corresponding part of the detailed description. Therefore, the terms used herein should be understood based on the meaning of the terms and content throughout the disclosure rather than merely designations of the terms.

While such terms as "first," "second," etc., may be used to describe various components, such components should not be limited by the terms. These terms are used only to distinguish one component from another. For example, a first component may be referred to as a second component, and a second component may be referred to as a first component in a similar manner, without departing from the scope of an embodiment of the disclosure.

It is to be understood that when a certain component is referred to as being "coupled to" or "connected to" another component, the component may be coupled to or connected to the other component directly, but may also be understood as having a different component therebetween. On the other hand, it is to be understood that when a certain component is referred to as being "directly coupled to" or "directly connected to" another component, no other component is present therebetween.

The singular expression may also include the plural meaning as long as it is not inconsistent with the context. All the terms used herein, including technical and scientific terms, may have the same meanings as those generally understood by those of skill in the art.

As used herein, terms such as "comprises," "includes," or "has" specify the presence of stated features, numbers, stages, operations, components, parts, or a combination thereof, but do not preclude the presence or addition of one or more other features, numbers, stages, operations, components, parts, or a combination thereof.

As used herein, a component expressed as, for example, '...er (or)', '... unit', '... module', or the like, may denote a unit in which two or more components are combined into one component or one component is divided into two or more components according to its function. In addition, each component to be described below may additionally perform, in addition to its primary function, some or all of functions of other components take charge of, and some functions among primary functions of the respective components may be exclusively performed by other components. According to an embodiment, the component expressed as, for example, '...er (or)', '... unit', '... module', or the like, may be implemented by a hardware, a software or a combination of a hardware and a software. For example, in case of a hardware, these components may be implement by a circuitry, a processors, etc. In case of a software, these components may be implement as a software code, a computer program and/or instructions, which can be implemented in by a processor or other circuits.

In the disclosure, functions related to artificial intelligence are performed by a processor and a memory. The processor may include one or more processors. In this case, the one or more processors may be a general-purpose processor, such as a central processing unit (CPU), an application processor (AP), or a digital signal processor (DSP), a dedicated graphics processor, such as a graphics processing unit (GPU) or a vision processing unit (VPU), or a dedicated artificial intelligence processor, such as a neural processing unit (NPU). The one or more processors perform control to process input data according to predefined operation rules or an artificial intelligence model stored in the memory. Alternatively, in a case in which the one or more processors are dedicated artificial intelligence processors, the dedicated artificial intelligence processor may be designed with a hardware structure specialized for processing a particular artificial intelligence model.

The predefined operation rules or artificial intelligence model may be generated via a training process. Here, being generated via a training process may mean that predefined operation rules or artificial intelligence model set to perform desired characteristics (or purposes), is generated by training a basic artificial intelligence model by using a learning algorithm that utilizes a large amount of training data. The training process may be performed by a device itself on which artificial intelligence according to the disclosure is performed, or by a separate server and/or system. Examples of learning algorithms may include, for example, supervised learning, unsupervised learning, semi-supervised learning, and reinforcement learning, but are not limited thereto.

The artificial intelligence model may include a plurality of neural network layers. Each of the neural network layers has a plurality of weight values, and performs a neural network arithmetic operation via an arithmetic operation between an arithmetic operation result of a previous layer and the plurality of weight values. A plurality of weight values in each of the neural network layers may be optimized by a result of training the artificial intelligence model. For example, the plurality of weight values may be refined to reduce or minimize a loss or cost value obtained by the artificial intelligence model during the training process. The artificial neural network may include, for example, a deep neural network (DNN) and may include, for example, a convolutional neural network (CNN), a deep neural network (DNN), a recurrent neural network (RNN), a restricted Boltzmann machine (RBM), a deep belief network (DBN), a bidirectional recurrent deep neural network (BRDNN), a deep Q-network (DQN), or the like, but is not limited thereto.

In the disclosure, a machine-readable storage medium may be provided in the form of a non-transitory storage medium. Here, the term 'non-transitory storage medium' refers to a tangible device and does not include a signal (e.g., an electromagnetic wave), and the term 'non-transitory storage medium' does not distinguish between a case where data is stored in a storage medium semi-permanently and a case where data is stored temporarily. For example, the non-transitory storage medium may include a buffer in which data is temporarily stored.

According to an embodiment of the disclosure, methods according to various aspects disclosed herein may be included in a computer program product and then provided. The computer program product may be traded as commodities between sellers and buyers. The computer program product may be distributed in the form of a machine-readable storage medium (e.g., a compact disc read-only memory (CD-ROM)), or may be distributed online (e.g., downloaded or uploaded) through an application store or directly between two user devices (e.g., smart phones). In a case of online distribution, at least a portion of the computer program product (e.g., a downloadable app) may be temporarily stored in a machine-readable storage medium such as a manufacturer's server, an application store's server, or a memory of a relay server.

Hereinafter, an embodiment of the disclosure will be described in detail with reference to the accompanying drawings to allow those of skill in the art to easily carry out the embodiment of the disclosure. The disclosure may, however, be embodied in many different forms and should not be construed as being limited to an embodiment of the disclosure set forth herein.

In the disclosure, the term 'background sound' may be understood as audios other than a candidate audio, among a plurality of audios included in a sound source. For example, in a case in which a voice of each of two particular speakers is to be separated from a sound source including voices of the speakers, voices of other people around the speakers, ambient noise from a surrounding environment, such as a sound of a car horn or shouts of a crowd, background music for creating an atmosphere of a scene where the speakers appear, and the like may be background sounds.

It is important to note that a candidate audio and a background sound are not distinguished by the types thereof. That is, the candidate audio and the background sound may be of the same type of sound or may be of different types of sound. For example, the candidate audio may be a voice of a particular speaker, and the background sound may be a voice of another person around the speaker. For example, the candidate audio may be a vocal of a singer, and the background sound may be an accompaniment to a song sung by the singer.

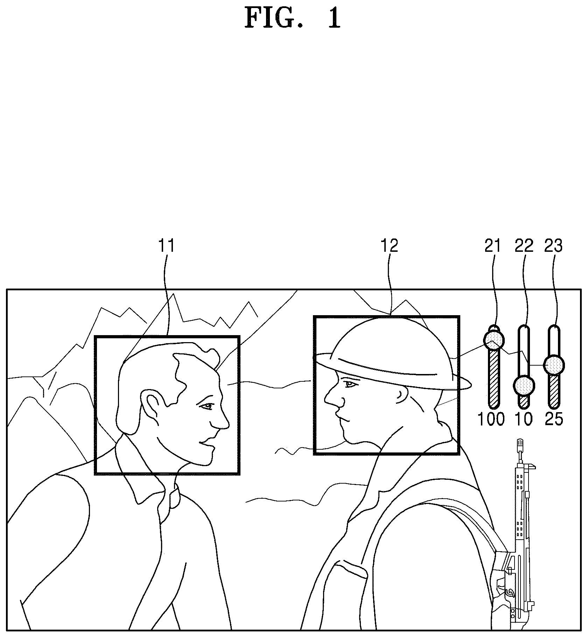

FIG. 1 is a diagram for describing a situation to which an audio separation method may be applied, according to an embodiment of the disclosure.

In FIG. 1, a war movie is reproduced on a screen, and a scene in which a first person 11 and a second person 12 having a conversation in a battlefield is displayed. In the scene, not only voices of the first person 11 and the second person 12 are output, but also background sounds such as painful moans of other nearby injured people, gunshots, sound effects of bombs exploding nearby, or music for creating a more intense and dramatic atmosphere for the scene may be output. In an example case in which the volume of such a background sound is much greater than the volume of the voices of the first person 11 and the second person 12, it may be difficult for a viewer to fully understand the content of the conversation between the first person 11 and the second person 12.

As illustrated in FIG. 1, in an example case in which a volume 21 of the voice of the first person 11, a volume 22 of the voice of the second person 12, and a volume 23 of the background sound are separately adjustable, the viewer may be able to better understand the conversation between the first person 11 and the second person 12 by lowering the volume of the background sound in the scene. In order to separately adjust the volume, it is necessary to separate the voice of the first person 11 and the voice of the second person 12 from a sound source in which various audios are mixed, and adjust the magnitude (i.e., volume) of a background sound included in the separated voice of each person.

Hereinafter, a method of separating one or more candidate audios, from a sound source including the one or more candidate audios and a background sound, and adjusting the magnitude of the background sound included in the separated audios will be described in detail.

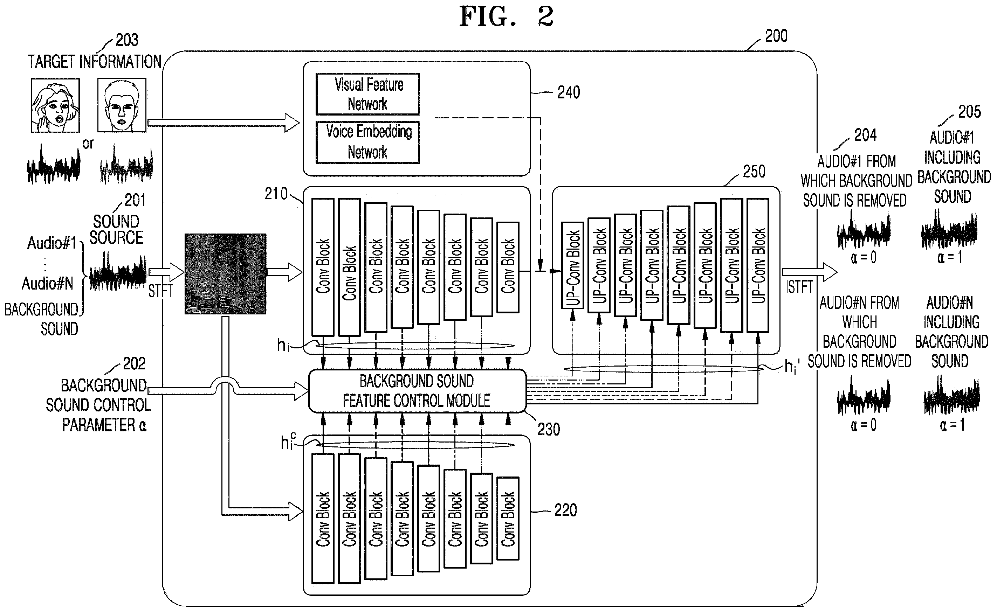

FIG. 2 illustrates an audio separation system 200 according to an embodiment of the disclosure.

In an embodiment of the disclosure, the audio separation system 200 may receive an input including a sound source 201, target information 203, and background sound control parameter 202. The sound source 201 may include one or more candidate audios Audio#1, ..., Audio#N and a background sound. The target information 203 may correspond to each candidate audio. The audio separation system 200 may output separated audios 204 and 205 in which the magnitude (i.e., volume) of the background sound is adjusted according to the background sound control parameter 202. The audio separation system 200 may be an artificial intelligence model trained by using training data.

The type of a candidate audio may be variously determined. In an embodiment of the disclosure, a candidate audio may be a human voice. For example, the candidate audio may be a speaker's speech, a singer's vocal, or the like. In an embodiment of the disclosure, a candidate audio may be a sound produced by a musical instrument or a machine. For example, the candidate audio may be a piano piece of music performed by an orchestra, an accompaniment to a song sung by a singer, or the like.

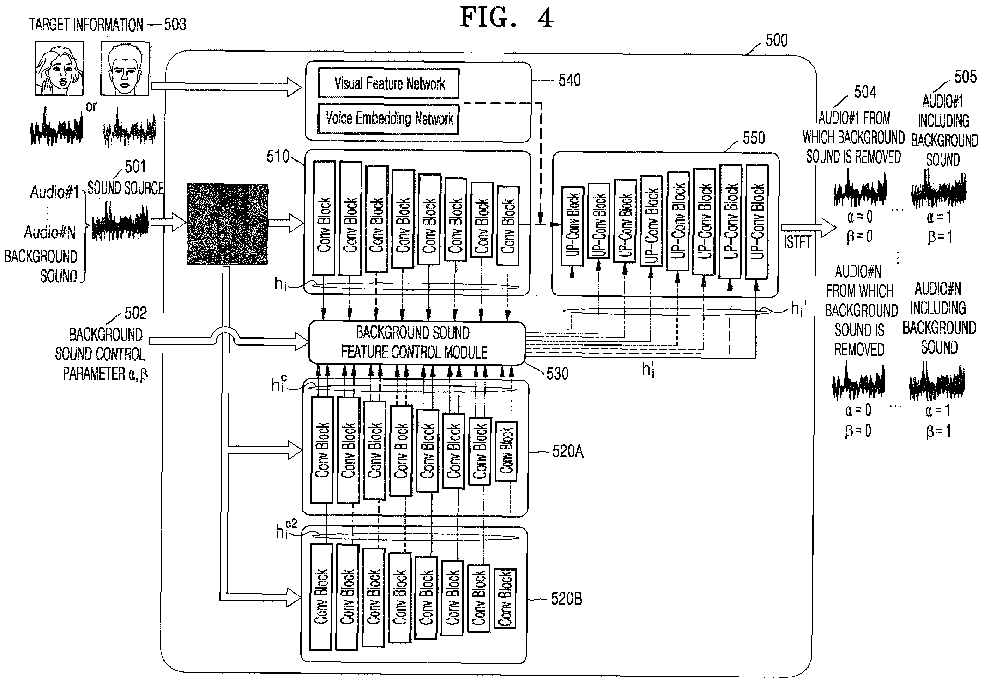

Depending on the type of training data, in an example case in which a plurality of audios are to be separated, the types of the candidate audios may be the same as or different from each other. In an embodiment of the disclosure, the audio separation system 200 may separate a plurality of candidate audios of the same type from the sound source 201. For example, the audio separation system 200 may separate, from a conversation between two speakers, a voice of each speaker. In an embodiment of the disclosure, the audio separation system 200 may separate a plurality of candidate audios of different types from the sound source 201. For example, the audio separation system 200 may separate, from a song sung by a singer, the singer's vocal and an accompaniment to the song. A process of training the audio separation system 200 will be described below with reference to FIG. 4.

The type of a background sound may be variously determined. In an embodiment of the disclosure, the type of a background sound may be the same as the type of a candidate audio. For example, in a case in which a candidate audio is a human voice, the background sound may be a voice of a speaker other than a speaker corresponding to the candidate audio. In an embodiment of the disclosure, the type of the background sound may be different from the type of the candidate audio. For example, in a case in which a candidate audio is a human voice, a background sound may be noise occurring around a speaker corresponding to the candidate audio, such as a sound of a car horn.

The target information 203 corresponding to the candidate audio may be information for specifying or distinguishing the candidate audio from among a plurality of audios included in the sound source 201. For example, the target information 203 may be understood as additional information for specifying which audio the audio separation system 200 needs to separate, from among a plurality of audios included in the sound source 201. In an embodiment of the disclosure, target information 203 may be visual information. For example, in a case in which the candidate audio is a human voice, the target information 203 may be an image including all or part of the face of a speaker corresponding to the candidate audio. For example, the target information 203 may be an image including a mouth area of a speaker corresponding to the candidate audio. However, the disclosure is not limited thereto. In an embodiment of the disclosure, the target information 203 may be audio information that is separate from the candidate audio. For example, in a case in which the candidate audio is a human voice, the target information 203 may be a pre-recorded voice of a speaker corresponding to the candidate audio. As another example, in a case in which the candidate audio is piano music, the target information 203 may be pre-recorded piano music.

The target information 203 corresponding to the candidate audio may be determined according to the candidate audio and original data. For example, in a case of separating voices of two speakers appearing in a video including audios and images, an image including the target speakers may be used as the target information 203. As another example, in a case of separating in which a voice of a speaker that appears in the video and a voice of another speaker that does not appear in the video, an image including the speaker that appears in the video and a pre-recorded voice of the speaker that does not appear in the video may each be used as the target information 203.

The background sound control parameter 202 may be a parameter $\alpha$ for determining the volume of a background sound to be included in the separated sound source 201. The background sound control parameter 202 may be determined by a user. For example, the background sound control parameter 202 may be determined by the user adjusting the volume of the background sound as illustrated in FIG. 1. In an embodiment of the disclosure, the background sound control parameter 202 may be a real number between 0 and 1. For example, the audio separation system 200 may, based on the background sound control parameter 202 being 0, output the separated audio 204 from which the background sound is removed, and based on the background sound control parameter 202 being 1, output the separated audio 205 including the background sound as it is. In other words, the audio separation system 200 may remove more of the background sound as the background sound control parameter 202 approaches 0, and may remove less of the background sound as the background sound control parameter 202 approaches 1. That is, an amount (or a magnitude) of background sound removed from the candidate audio is based on the background sound control parameter. For example, the amount (or the magnitude) of background sound removed from the candidate audio may be proportional to the background sound control parameter. However, the disclosure is not limited thereto, and as such, the background sound control parameter 202 may be identified in a different manner. For example, the background sound control parameter 202 may include a range of numbers different from 0 and 1. In another example, the background sound control parameter 202 may be include a non-numeric identifier.

In an embodiment of the disclosure, the audio separation system 200 may generate a spectrogram of the sound source 201. According to an example, the audio separation system 200 may generate a spectrogram of the sound source 201 by applying a short-time Fourier transform (STFT) on the sound source 201. A spectrogram refers to a visual representation of the sound source 201. For example, the spectogram may represent differences in amplitude according to changes in time and frequency in the time-frequency domain are expressed as differences in color or density between pixels.

In an embodiment of the disclosure, the audio separation system 200 may extract a first audio feature $h_i$ from the sound source 201 by processing the spectrogram of the sound source 201 by using an audio feature extraction module 210. In an embodiment of the disclosure, the audio feature extraction module 210 may include a plurality of convolution blocks, each of which may include one or more convolutional layers, batch normalization, and an activation function. The activation function may include, but is not limited to ReLu or sigmoid. In the audio feature extraction module 210, a feature extracted by one convolution block may be transferred to the next convolution block, and thus, the first audio feature $h_i$ may be extracted by each convolution block. Here, i is a natural number, and $h_i$ denotes a first audio feature extracted by an i-th convolution block. For example, as illustrated in FIG. 2, in a case in which the audio feature extraction module 210 includes eight convolution blocks, the convolution blocks may extract first audio features (e.g., $h_1$, $h_2$, ..., $h_8$) corresponding to the convolution blocks, respectively.

In an embodiment of the disclosure, the audio separation system 200 may extract a background sound feature $h_i^c$ from the sound source 201 by processing the spectrogram of the sound source 201 by using a background sound analysis module 220. In an embodiment of the disclosure, the background sound analysis module 220 may include a plurality of convolution blocks, each of which may include one or more convolutional layers, batch normalization, and an activation function (e.g., ReLu or sigmoid). In an embodiment of the disclosure, the background sound analysis module 220 may be implemented in the same structure as the audio feature extraction module 210. In the background sound analysis module 220, features extracted by one convolution block may be transferred to the next convolution block, and thus, the background sound feature $h_i^c$ may be extracted by each convolution block. Here, I is a natural number, and $h_i^c$ denotes a background sound feature extracted by an i-th convolution block. For example, as illustrated in FIG. 2, in a case in which the background sound analysis module 220 includes eight convolution blocks, the convolution blocks may extract background sound features (i.e., h1c, h2c, ..., h8c) corresponding to the convolution blocks, respectively.

The background sound feature $h_i^c$ may have a value of any real number, and may be understood as indicating a degree of association between the first audio feature $h_i$ corresponding to the respective background sound feature $h_i^c$ and the background sound. For example, it may be understood that, as the size of the background sound feature $h_i^c$ increases, the first audio feature $h_i$ corresponding to the respective background sound feature $h_i^c$ contributes more to generating the background sound, and as the size of the background sound feature $h_i^c$ decreases, the first audio feature $h_i$ corresponding to the respective background sound feature $h_i^c$ contributes less to generating the background sound. For example, in a case in which, the background sound feature $h_i^c$ increases, the first audio feature $h_1$ corresponding to the respective background sound feature $h_1^c$ contributes more or may have a higher effect on generating the background sound. On the other hand, as the size of the background sound feature $h_1^c$ decreases, the first audio feature $h_1$ corresponding to the

respective background sound feature $h_1^c$ contributes less or may have a lower effect on generating the background sound.

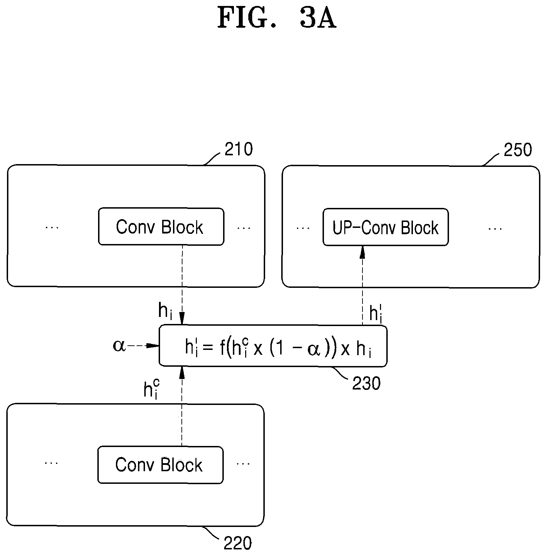

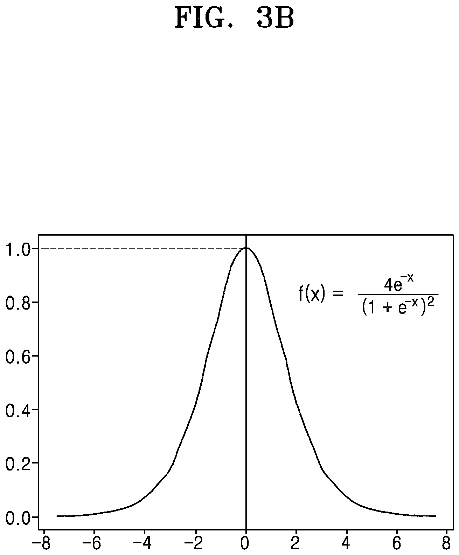

In an embodiment of the disclosure, the audio separation system 200 may generate a second audio feature hi' in which the background sound is adjusted, by processing the first audio feature hi by using a background sound feature control module 230. An operation of the background sound feature control module 230 will be described below with reference to FIG. 3.

In an embodiment of the disclosure, the audio separation system 200 may extract a target feature from the target information 203 by processing the target information 203 by using a target feature extraction module 240. The target feature extraction module 240 may be implemented in a form suitable for processing the target information 203. For example, in a case in which the target information 203 is visual information, the target feature extraction module 240 may be a visual feature network (e.g., a CNN) capable of extracting visual features from visual information. As another example, in a case in which the target information 203 is audio information, the target feature extraction module 240 may be a voice embedding network (e.g., a CNN) capable of generating an audio embedding from audio information.

In an embodiment of the disclosure, the audio separation system 200 may generate a spectrogram of the separated audio by processing the first audio feature, the second audio feature, and the target feature by using an audio generation module 250. In an embodiment of the disclosure, the audio generation module 250 may include a plurality of up-convolution blocks, each of which may include one or more transposed convolutional layers, concatenation, and a convolution block. In the audio generation module 250, features generated by one up-convolution block may be transferred to the next up-convolution block, and thus, a spectrogram of a separated audio may be generated. Each up-convolution block generates features to be transferred to the next up-convolution block, by processing the features generated by the previous up-convolution block and the second audio feature hi'. Here, a j-th up-convolution block generates a feature to be transferred to the next up-convolution block by using a feature generated by a (j-1)-th up-convolution block, and the second audio feature hi' generated by processing the first audio feature $h_i$ extracted by a convolution block corresponding to the j-th up-convolution block (e.g., an (n-j+1)-th convolution block in a case in which the numbers of convolution blocks and up-convolution blocks are n). The first up-convolution block generates a feature to be transferred to the second up-convolution block, by using a feature obtained by concatenating the first audio feature $h_i$ extracted by the last convolution block with the target feature, and a second audio feature generated by processing a first audio feature extracted by the last convolution block.

The operation in which the second audio feature hi' is generated from the first audio feature $h_i$ generated by a corresponding convolution block and transferred to a corresponding up-convolutional block may be understood as a kind of skip-connection. In other words, the audio separation system 200 may adjust the magnitude of a background sound included in a separated audio, by adjusting the size of a feature directly transferred from a convolution block to an up-convolution block through the background sound analysis module 220 and the background sound feature control module 230.

In an embodiment of the disclosure, the audio separation system 200 may generate a separated audio by applying an inverse STFT (ISTFT) on a spectrogram of a separated audio.

FIG. 3a is a diagram for describing an operation of the background sound feature control module 230 according to an embodiment of the disclosure, and FIG. 3b shows an example of a background sound control function.

As illustrated in FIG. 3a, in an embodiment of the disclosure, the background sound feature control module 230 may generate the second audio feature $h_i'$ in which a background sound is adjusted, by scaling the first audio feature $h_i$ according to the degree to which the first audio feature $h_i$ is associated with the background sound, based on the background sound control parameter 202 (e.g., $\alpha$) and the background sound feature $h_i^c$. Here, the degree to which the first audio feature $h_i$ is associated with the background sound may be understood as the contribution of the first audio feature $h_i$ to the background sound to be included in the separated audio in a case in which the separated audio is generated by the audio generation module 250.

For example, in a case in which the background sound control parameter 202 is 1 ($\alpha = 1$), it means that the user does not want to adjust the background sound, and thus, the background sound feature control module 230 may not scale the first audio feature $h_i$ such that the first audio feature $h_i$ is transferred to the up-convolution block as it is. In other words, the background sound feature control module 230 may scale the first audio feature $h_i$ by 1.

For example, in a case in which the background sound control parameter 202 is 0 ($\alpha = 0$), it means that the user wants to remove the background sound, and thus, the background sound feature control module 230 may scale the first audio feature $h_i$ by a smaller scaling factor as the size of the background sound feature $h_i^c$ increases, such that the first audio feature $h_i$, which much contributes to generating the background sound, is reduced in size and then transferred to the up-convolution block. In other words, as the size of the background sound feature $h_i^c$ increases, the scaling factor may approach 0.

For example, in a case in which the background sound control parameter 202 is 0 ($\alpha = 0$), it means that the user wants to remove the background sound, and thus, the background sound feature control module 230 may scale the first audio feature $h_i$ by a larger scaling factor as the size of the background sound feature $h_i^c$ decreases, such that the first audio feature $h_i$, which little contributes to generating the background sound, is transferred to the up-convolution block as intact as possible. In other words, as the size of the background sound feature $h_i^c$ decreases, the scaling factor may approach 1.

In an embodiment of the disclosure, the background sound feature control module 230 may generate the second audio feature $h_i'$ in which the background sound is adjusted, by scaling the first audio feature $h_i$ according to Equation 1.

【Equation 1】

$$h_i^{'} = f\left(h_i^c \times (1-\alpha)\right) \times h_i$$

Here, $h_i$ denotes a first audio feature, $h_i^c$ is a background sound feature, $h_i'$ denotes a second audio feature, $\alpha$ denotes a background sound control parameter, and f(x) denotes a background sound control function.

As shown in FIG. 3b, in an embodiment of the disclosure, the background sound control function f(x) may be an arbitrary function that is symmetric with respect to x = 0 (i.e., is symmetric with respect to the y axis), approaches 0 as the absolute value of x (i.e., |x|) increases, and satisfies f(0) = 1. For example, the background sound control function f(x) may be the function of Equation 2.

【Equation 2】

$$f(x) = \frac{4e^{-x}}{(1+e^{-x})^2}$$

In a case in which the background sound control parameter 202 is 1 ($\alpha = 1$), $h_i' = f(0) \times h_i = h_i$, and thus, the background sound feature control module 230 does not scale the first audio feature $h_i$. In other words, the background sound feature control module 230 scales the first audio feature $h_i$ by 1.

In a case in which the background sound control parameter 202 is close to 0 ($\alpha$ is close to 0) and $|h_i^c|$ is sufficiently large, $f(h_i^c \times (1-\alpha))$ approaches 0, and thus, the background sound feature control module 230 scales the first audio feature $h_i$ corresponding to the large background sound feature $h_i^c$ by a scaling factor that is close to 0.

In a case in which $|h_i^c|$ is sufficiently small, $(h_i^c \times (1-\alpha))$ approaches 1 even when the background sound control parameter 202 is close to 0 ($\alpha$ is close to 0), and thus, the background sound feature control module 230 scales the first audio feature $h_i$ corresponding to the small background sound feature $h_i^c$ by a scaling factor that is close to 1.

FIG. 4 is a diagram for describing a method of training the audio separation system 200, according to an embodiment of the disclosure.

In an embodiment of the disclosure, training of the audio separation system 200 may be performed by comparing a target result 405 with an audio separation result 404 inferred by the audio separation system 200 for a training sound source 401. Here, training may be understood as updating weight values in the audio feature extraction module 210, the background sound analysis module 220, the background sound feature control module 230, and the audio generation module 250 that are included in the audio separation system 200. A certain loss function (e.g., mean squared error or cross-entropy error) may be used for comparing the inferred audio separation result 404 with the target result 405.

In an embodiment of the disclosure, the training sound source 401 may include one or more training candidate audios.

In an embodiment of the disclosure, the training candidate audios may be determined according to the purpose of the audio separation system 200. For example, as illustrated in FIG. 1, in a case in which the purpose is to separate a voice of each character in a movie so as to adjust the volumes of the voice of each character and a background sound, the training candidate audios may be determined to be human voices. As another example, in a case in which the purpose is to separate a vocal of a singer and an accompaniment to a song sung by the singer in a video of live performance of the singer that includes shouts of an audience, the training candidate audios may be determined to be human voices and sounds produced by musical instruments.

In an embodiment of the disclosure, the training sound source 401 may include training background sounds.

In an embodiment of the disclosure, the training background sounds may be determined depending on the purpose of the audio separation system 200. For example, in a case in which the purpose is to separate a vocal of a singer in a video of live performance of the singer, the training background sounds may be determined to be sounds produced by musical instruments.

In an embodiment of the disclosure, the training background sounds may be arbitrary noise. For example, the training background sounds may be white noise.

In an embodiment of the disclosure, the training sound source 401 may be generated by mixing one or more training candidate audios with training background sounds at a certain volume ratio. For example, the training sound source 401 may be a sound source in which voices of two speakers are mixed with white noise at a volume ratio of 2:1. However, the disclosure is not limited thereto, and as such, the ratio may be different than 2:1.

In an embodiment of the disclosure, training target information 403 may be determined to correspond to the training candidate audios. For example, in a case in which the training candidate audios are human voices, the training target information 403 may be an image including all or part of the face (e.g., a mouth area) of a corresponding speaker, or a pre-recorded voice of the corresponding speaker. As another example, in a case in which the training candidate audios are sounds produced by musical instruments, the training target information 403 may be a pre-recorded sound produced by a corresponding musical instrument.

In an embodiment of the disclosure, the audio separation system 200 may be trained for a plurality of cases corresponding to a plurality of background sound parameters 402. Here, a separate target result may be used for each case. For example, as illustrated in FIG. 4, the audio separation system 200 may be trained for a first case in which a background sound parameter 402 is 0 (e.g., $\alpha = 0$), a second case in which the background sound parameter 402 is 0.5 (e.g., $\alpha = 0.5$), and a third case in which the background sound parameter 402 is 1 (e.g., $\alpha = 1$). Here, the target result 405 for the first case may be a training candidate audio $\hat{x}$ from which a background sound is removed, the target result 405 for the second case may be an average $(x-\hat{x})/2$ of the training candidate audio $\hat{x}$ from which the background sound is removed, and a training candidate audio x including the background sound, and the target result 405 for the third case may be the training candidate audio x including the background sound.

In an embodiment of the disclosure, the training sound source 401 may be generated by mixing random noise with an original audio including one or more candidate audios, the target result 405 may be generated by removing the noise from the training sound source 401 by using a denoising model. For example, the denoising model may be an artificial intelligence model.

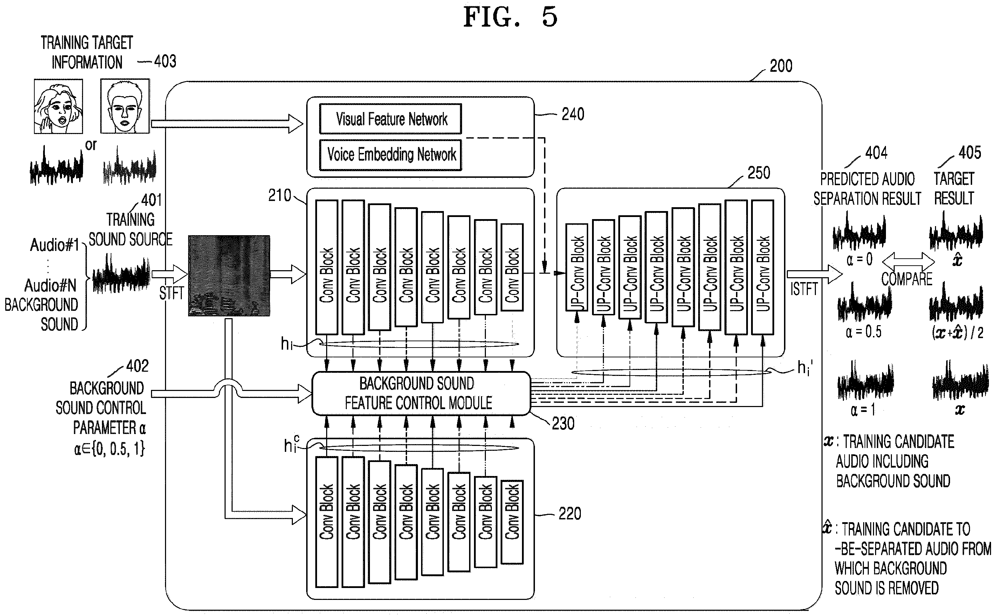

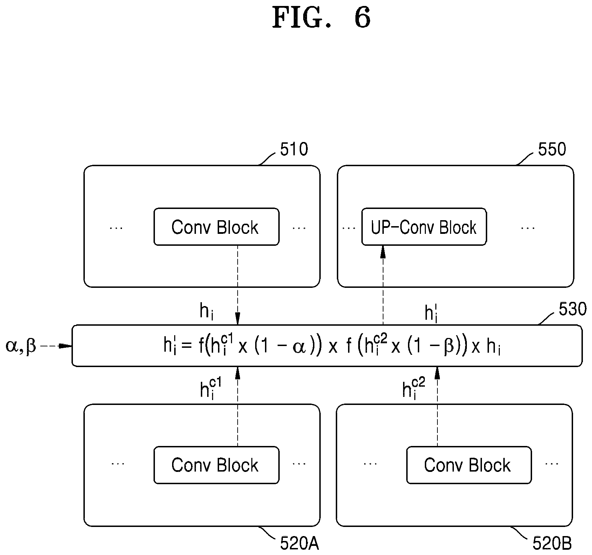

FIG. 5 illustrates an audio separation system 500 according to an embodiment of the disclosure, and FIG. 6 is a diagram for describing an operation of a background sound feature control module 530 according to an embodiment of the disclosure.

In separating one or more audios from a sound source 501 including a plurality of audios, candidate audios and background sounds may be determined according to the design of the audio separation system (e.g., a network structure or settings of candidate audios and target information), and a training method (e.g., training candidate audios, training background sounds, or settings of target results). In addition, the background sounds may be classified into two or more types depending on the design of the audio separation system and the training method. For example, for a sound source including a vocal of a singer, an accompaniment to a song, and ambient noise (e.g., shouts or applause of an audience), the vocal of the singer and the accompaniment to the song may be set as candidate audios, and the ambient noise may be set a background sound. Alternatively, the vocal of the singer may be set as a candidate audio, and the accompaniment to the song and the ambient noise may be as background sounds. The audio separation system 500 illustrated in FIG. 5 may be used to obtain audio separation results in which two or more background sounds may be individually adjusted, for example, in a case in which an accompaniment to a song and ambient noise are set as background sounds.

Compared to the audio separation system 200 of FIG. 2, the audio separation system 500 of FIG. 5 is configured to receive a background sound control parameter 502 ($\beta$) as an additional input, and includes an additional background sound feature extraction module 520B. The audio separation system 500 of FIG. 5 is an example that may be applied to a case of adjusting two background sounds, but is not limited to the case, and it will be apparent to those of skill in the art that the audio separation system 500 may be modified to receive a larger number of background sound control parameters and include a larger number of background sound feature extraction modules, in order to adjust a larger number of background sounds. Hereinafter, an operation of the audio separation system 500 will be described without redundant descriptions of the operation of the audio separation system 200 provided above.

In an embodiment of the disclosure, the audio separation system 500 may receive an input of the sound source 501 including one or more candidate audios Audio#1, ..., Audio#N and a background sound, target information 503 corresponding to each candidate audio, and background sound control parameters 502 (e.g., $\alpha$ and $\beta$), and output separated audios 504 and 505 in which the magnitude of the background sound is adjusted according to the background sound control parameters 502 (e.g., $\alpha$ and $\beta$). The audio separation system 500 may be an artificial intelligence model trained by using training data.

The background sound control parameter a is a parameter for determining the volume of a first background sound to be included in the separated sound sources 504 and 505. The background sound control parameter $\alpha$ may be determined by a user. In an embodiment of the disclosure, the background sound control parameter $\alpha$ may be a real number between 0 and 1. For example, the audio separation system 500 may, based on the background sound control parameter $\alpha$ being 0, output the separated audio 504 from which the first background sound is removed, and based on the background sound control parameter $\alpha$ being 1, output the separated audio 505 including the first background sound as it is (e.g., without the background sound being removed). In other words, the audio separation system 500 may remove more of the first background sound as the background sound control parameter $\alpha$ approaches 0, and may remove less of the first background sound as the background sound control parameter $\alpha$ approaches 1.

The background sound control parameter $\beta$ is a parameter for determining the volume of a second background sound to be included in the separated sound sources 504 and 505. The background sound control

parameter $\beta$ may be determined by the user. In an embodiment of the disclosure, the background sound control parameter $\beta$ may be a real number between 0 and 1. For example, the audio separation system 500 may, based on the background sound control parameter $\beta$ being 0, output the separated audio 504 from which the second background sound is removed, and based on the background sound control parameter $\beta$ being 1, output the separated audio 505 including the second background sound as it is. In other words, the audio separation system 500 may further remove the second background sound as the background sound control parameter $\beta$ approaches 0, and may less remove the second background sound as the background sound control parameter $\beta$ approaches 1.

In an embodiment of the disclosure, the audio separation system 500 may extract a first background sound feature $h_i^{c1}$ from the sound source 501 by processing a spectrogram of the sound source 501 by using a first background sound analysis module 520A. In an embodiment of the disclosure, the first background sound analysis module 520A may include a plurality of convolution blocks, each of which may include one or more convolutional layers, batch normalization, and an activation function (e.g., ReLu or sigmoid). In an embodiment of the disclosure, the first background sound analysis module 520A may be implemented in the same structure as an audio feature extraction module 510. In the first background sound analysis module 520A, a feature extracted by one convolution block may be transferred to the next convolution block, and thus, the first background sound feature $h_i^{c1}$ may be extracted by each convolution block. Here, i is a natural number, and $h_i^{c1}$ denotes a first background sound feature extracted by an i-th convolution block. For example, as illustrated in FIG. 5, in a case in which the first background sound analysis module 520A includes eight convolution blocks, the convolution blocks may extract first background sound features (i.e., $h_1^{c1}$, $h_2^{c1}$, ..., $h_8^{c1}$) corresponding thereto, respectively.

The first background sound feature $h_i^{c1}$ may have a value of any real number, and may be understood as indicating the degree to which the first audio feature $h_i$ corresponding thereto is associated with the first background sound. That is, it may be understood that, as the size of the first background sound feature $h_i^{c1}$ increases, the first audio feature $h_i$ corresponding thereto more contributes to generating the first background sound, and as the size of the first background sound feature $h_i^{c1}$ decreases, the first audio feature $h_i$ corresponding thereto less contributes to generating the first background sound.

In an embodiment of the disclosure, the audio separation system 500 may extract a second background sound feature $h_i^{c2}$ from the sound source 501 by processing the spectrogram of the sound source 501 by using the second background sound analysis module 520B. In an embodiment of the disclosure, the second background sound analysis module 520B may include a plurality of convolution blocks, each of which may include one or more convolutional layers, batch normalization, and an activation function (e.g., ReLu or sigmoid). In an embodiment of the disclosure, the second background sound analysis module 520B may be implemented in the same structure as the audio feature extraction module 510. In the second background sound analysis module 520B, a feature extracted by one convolution block may be transferred to the next convolution block, and thus, the second background sound feature $h_i^{c2}$ may be extracted by each convolution block. Here, i is a natural number, and $h_i^{c2}$ denotes a second background sound feature extracted by an i-th convolution block. For example, as illustrated in FIG. 5, in a case in which the second background sound analysis module 520B includes eight convolution blocks, the convolution blocks may extract second background sound features (i.e., $h_1^{c2}$, $h_2^{c2}$, ..., $h_8^{c2}$) corresponding thereto, respectively.

The second background sound feature $h_i^{c2}$ may have a value of any real number, and may be understood as indicating the degree to which the first audio feature $h_i$ corresponding thereto is associated with the second background sound. That is, it may be understood that, as the size of the second background sound feature $h_i^{c2}$ increases, the first audio feature $h_i$ corresponding thereto more contributes to generating the second background sound, and as the size of the second background sound feature $h_i^{c2}$ decreases, the first audio feature $h_i$ corresponding thereto less contributes to generating the second background sound.

In an embodiment of the disclosure, the audio separation system 500 may generate the second audio feature $h_i'$ in which the first background sound and the second background sound are adjusted, by processing the first audio feature $h_i$ by using the background sound feature control module 530.

As illustrated in FIG. 6, the background sound feature control module 530 may generate the second audio feature hi' in which the first background sounds and the second background sound are adjusted, by scaling the first audio feature $h_i$ according to the degrees to which the first audio feature $h_i$ is associated with the first background sound and the second background sound, respectively, based on the background sound control parameters $\alpha$ and $\beta$, the first background sound feature $h_i^{c1}$ and the second background sound feature $h_i^{c2}$. Here, the degrees to which the first audio feature $h_i$ is associated with the first background sound and the second background sound, respectively, may be understood as the contribution of the first audio feature $h_i$ to the first background sound and the second background sound to be included in the separated audio in a case in which the separated audio is generated by an audio generation module 550.

In an embodiment of the disclosure, the background sound feature control module 530 may generate the second audio feature $h_i'$ in which the first background sound and the second background sound are adjusted, by scaling the first audio feature $h_i$ according to Equation 3.

【Equation 3】

$$h_i^{'} = f(h_i^{c1} \times (1-\alpha)) \times f(h_i^{c2} \times (1-\beta)) \times h_i$$

Here, $h_i$ denotes a first audio feature, $h_i^{c1}$ denotes a first background sound feature, $h_i^{c2}$ denotes a second background sound feature, $h_i^{'}$ denotes a second audio feature, $\alpha$ and $\beta$ denote background sound control parameters, and f(x) denotes a background sound control function.

In an embodiment of the disclosure, the background sound control function f(x) may be an arbitrary function that is symmetric with respect to x = 0 (i.e., is symmetric with respect to the y axis), approaches 0 as the absolute value of x (i.e., |x|) increases, and satisfies f(0) = 1. For example, the background sound control function f(x) may be the function of Equation 2, as shown in FIG. 3b.

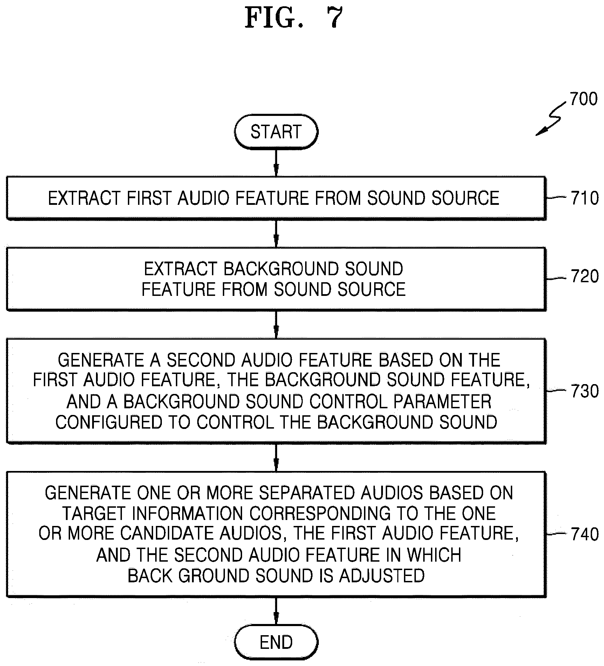

FIG. 7 is a flowchart of an audio separation method 700 according to an embodiment of the disclosure.

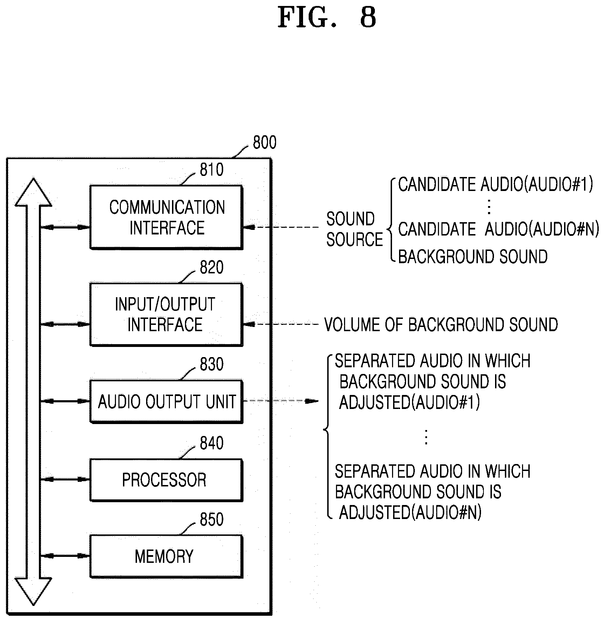

The audio separation method 700 of FIG. 7 is for separating one or more candidate audios from a sound source including the one or more candidate audios and a background sound by using the audio separation system 200 or 500. The audio separation method 700 may be performed by an electronic device 800 of FIG. 8.

In operation 710, the method may include extracting a first audio feature $h_i$ from the sound source.

In an embodiment of the disclosure, the operation 710 may include generating a spectrogram of the sound source by applying an STFT on the sound source, and processing the spectrogram of the sound source by using the audio feature extraction module 210 or 510 including a plurality of convolution blocks, in order to extract the first audio feature $h_i$ from the sound source.

In operation 720, the method may include extracting a background sound feature $h_i^c$ from the sound source.

In an embodiment of the disclosure, the operation 720 may include generating a spectrogram of the sound source by applying an STFT on the sound source, and processing the spectrogram of the sound source by using the background sound analysis module 220, 520A, or 520B including a plurality of convolution blocks, in order to extract the background sound feature $h_i^c$ from the sound source.

In an embodiment of the disclosure, the operation 720 may include extracting a first background sound feature $h_i^{c1}$ from the sound source, and extracting a second background sound feature $h_i^{c2}$ from the sound source.

In operation 730, the method may include generating a second audio feature $h_i^{'}$ based on the first audio feature $h_i$ and the background sound. For example, the first audio feature $h_i$ is processed according to the degree to which the first audio feature $h_i$ is associated with the background sound, based on a background sound control parameter $\alpha$ and the background sound feature $h_i^c$, to generate a second audio feature $h_i^{'}$ in which the background sound is adjusted.

In an embodiment of the disclosure, the operation 730 may include determining a scaling factor based on the background sound control parameter $\alpha$ and the background sound feature $h_i^c$, and generating the second audio feature $h_i^{'}$ in which the background sound is adjusted, by scaling the first audio feature $h_i$ by using the scaling factor.

In an embodiment of the disclosure, the determining of the scaling factor based on the background sound control parameter $\alpha$ and the background sound feature $h_i^c$ may include, based on the background sound control parameter $\alpha$ being 1, determining the scaling factor to be 1, based on the background sound control parameter $\alpha$ being 0, determining the scaling factor to be a smaller number as the size of the background sound feature $h_i^c$ increases, and based on the background sound control parameter $\alpha$ being 0, determining the scaling factor to be a larger number as the size of the background sound feature $h_i^c$ decreases. Here, the scaling factor is greater than 0 but less than or equal to 1.

In an embodiment of the disclosure, in the determining the scaling factor based on the background sound control parameter $\alpha$ and the background sound feature $h_i^c$, the scaling factor may be determined according to $h_i^{'} = f(h_i^{c} \times (1-\alpha)) \times h_i$. Here, f(x) satisfies f(0) = 1, is symmetric with respect to x = 0, and is a background sound control function that approaches 0 as the absolute value of x increases.

In an embodiment of the disclosure, the background sound control function may be the function of Equation 2.

In an embodiment of the disclosure, the operation 730 may include determining the scaling factor based on a first background sound control parameter $\alpha$, a second background sound control parameter $\beta$, a first background sound feature $h_i^{c1}$, and a second back-ground sound feature $h_i^{c2}$, and generating the second audio feature $h_i^{'}$ in which the background sound is adjusted, by scaling the first audio feature $h_i$ by using the scaling factor.

In an embodiment of the disclosure, the determining of the scaling factor based on the first background sound control parameter $\alpha$, the second background sound control parameter $\beta$, the first background sound feature $h_i^{c1}$, and the second background sound feature $h_i^{c2}$ may include determining the scaling factor according to

$$h_i^{'} = f(h_i^{c1} \times (1-\alpha)) \times f(h_i^{c2} \times (1-\beta)) \times h_i$$

. Here, f(x) satisfies f(0) = 1, is symmetric with respect to x = 0, and is a background sound control function that approaches 0 as the absolute value of x increases.

In operation 740, the method may include generating one or more separated audios by using target information corresponding to a candidate audio, the first audio feature, and the second audio feature in which the background sound is adjusted.

In an embodiment of the disclosure, the operation 740 may include extracting a target feature from the target information corresponding to the candidate audio by using the target feature extraction module 240, processing the target feature, the first audio feature, and the second audio feature by using the audio generation module 250 including a plurality of up-convolution blocks, to generate a spectrogram of a separated audio, and generating the separated audio by applying an ISTFT on the spectrogram of the separated audio.

FIG. 8 is a block diagram schematically illustrating a configuration of the electronic device 800 for performing an audio separation method, according to an embodiment of the disclosure.

The electronic device 800 illustrated in FIG. 8 may be a display device for reproducing a video (e.g., a smart phone, a tablet, or a television), or may be a separate server connected to a display device through wired or wireless communication. The audio separation method described in the disclosure may be performed by a display device for reproducing a video, may be performed by a separate server connected to a display device, or may be performed by a display device and a server in cooperation with each other.

Referring to FIG. 8, in an embodiment of the disclosure, the electronic device 800 may include a communication interface 810, an input/output interface 820, an audio output unit 830, a processor 840, and a memory 850. However, the components of the electronic device 800 are not limited to the above-described examples, and the electronic device 800 may include more or fewer components than the above-described components. In an embodiment of the disclosure, some or all of the communication interface 810, the input/output interface 820, the audio output unit 830, the processor 840, and the memory 850 may be implemented as a single chip, and the processor 840 may include one or more processors.

For example, the electronic device 800 may receive a sound source including one or more candidate audios and a background sound, from an external device through the communication interface 810. Here, the sound source may be received in a form including only audio signals, or may be received in a form included in a video. The received sound source may be stored in the memory 850. Meanwhile, the electronic device 800 may separate one or more candidate audios from a sound source previously stored in the memory 850.

In addition, the electronic device 800 may receive an input for setting the volume of a background sound, from a user through the input/output interface 820. In this case, the processor 840 may determine background sound control parameters α and β based on the input volume of the background sound.

In addition, the electronic device 800 may separate one or more candidate audios from a sound source by using the audio separation system 200 or 500 stored in the memory 850, through the processor 840.

For example, based on a completion of audio separation, the electronic device 800 may output separated audios Audio#1, ..., Audio#N in which the background sound is adjusted, through the audio output unit 830. Here, the user may individually adjust the volume of each separated audio.

In an embodiment of the disclosure, the communication interface 810 is a component for transmitting and receiving signals (e.g., control commands or data) to and from an external device in a wired or wireless manner, and may include a communication chipset that supports various communication protocols. The communication interface 810 may receive a signal from the outside and output the signal to the processor 840, or transmit, to the outside, a signal output from the processor 840. According to an embodiment of the disclosure, the communication interface 810 may receive a sound source including one or more candidate audios and a background sound, from the outside.

In an embodiment of the disclosure, the input/output interface 820 may include an input interface (e.g., a touch screen, a hard button, or a microphone) for receiving a control command or information from a user, and an output interface (e.g., a display panel) for indicating a result of executing an operation according to control of the user, or a state of the electronic device 800. According to an embodiment of the disclosure, the input/output interface 820 may display a video being reproduced, and receive an input for adjust the volume of a background sound included in the sound source, from the user.

In an embodiment of the disclosure, the audio output unit 830 is a component for outputting an audio signal, and may be an output device (e.g., a built-in speaker) built into the electronic device 800 to directly reproduce a sound corresponding to an audio signal, may be an interface (e.g. a 3.5-mm port, a 4.4-mm port, a RCA port, a USB port) for allowing the electronic device 800 to transmit and receive audio signals to and from a wired audio reproducing device (e.g. a speaker, a sound bar, an earphone, or a headphone), or may be an interface (e.g., a Bluetooth module or a wireless local area network (WLAN) module) for allowing the electronic device 800 to transmit and receive audio signals to and from a wireless audio reproducing device (e.g., a wireless earphone, a wireless headphone, or a wireless speaker).

In an embodiment of the disclosure, the processor 840 is a component configured to control a series of processes such that the electronic device 800 operates, and may include one or more processors. In this case, the one or more processors may be general-purpose processors such as a central processing unit (CPU), an application processor (AP), or a digital signal processor (DSP), dedicated graphics processors such as a graphics processing unit (GPU) or a vision processing unit (VPU), or dedicated artificial intelligence processors such as a neural processing unit (NPU). For example, in a case in which the one or more processors are dedicated artificial intelligence processors, the dedicated artificial intelligence processor may be designed with a hardware structure specialized for processing a particular artificial intelligence model.

In an embodiment of the disclosure, the processor 840 may write data in the memory 850 or read data stored in the memory 850, and in particular, may execute a program stored in the memory 850 to process data according to a predefined operation rule or an artificial intelligence model. Thus, the processor 840 may perform the operations described herein, and the operations described herein to be performed by the electronic device 800 may be performed by the processor 840 unless otherwise specified.

In an embodiment of the disclosure, the memory 850 is a component for storing various programs or data, and may include a storage medium such as read-only memory (ROM), random-access memory (RAM), a hard disk, a compact disc ROM (CD-ROM), or a digital video disc (DVD), or a combination of storage media. The memory 850 may not be a separate component and may be included in the processor 840. The memory 850 may include a volatile memory, a nonvolatile memory, or a combination of a volatile memory and a nonvolatile memory. The memory 850 may store a program for performing the operations according to the embodiments described herein. For example, the memory 850 may store a program corresponding to an audio separation system. The memory 850 may provide data stored therein to the processor 840 in response to a request from the processor 840.

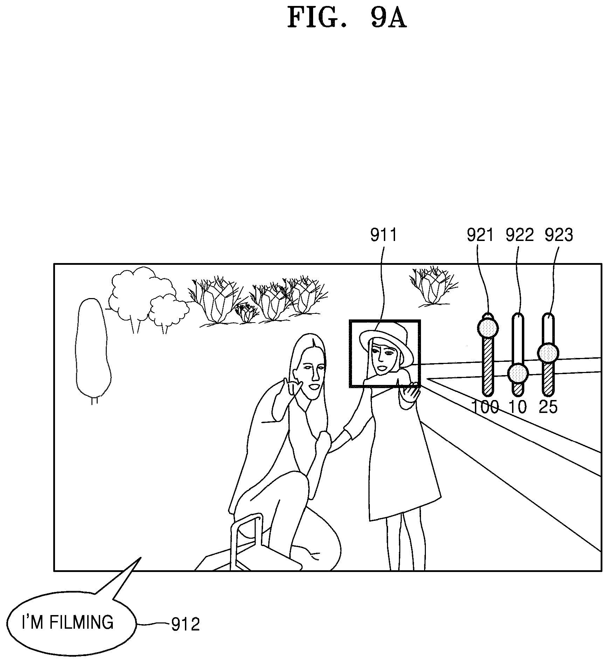

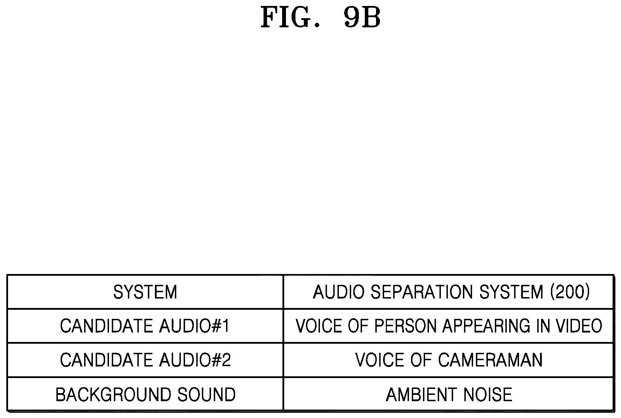

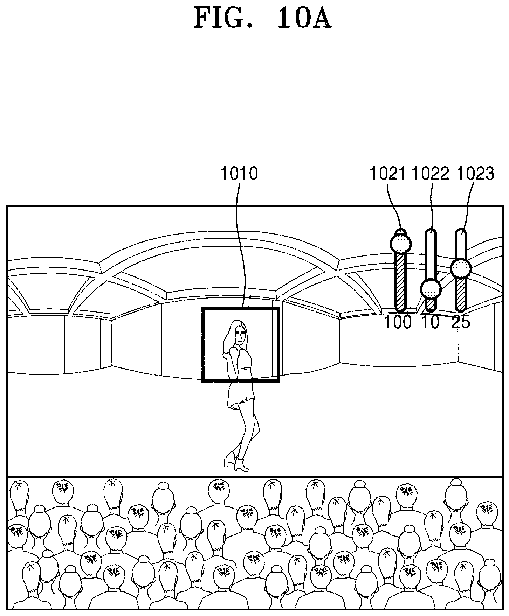

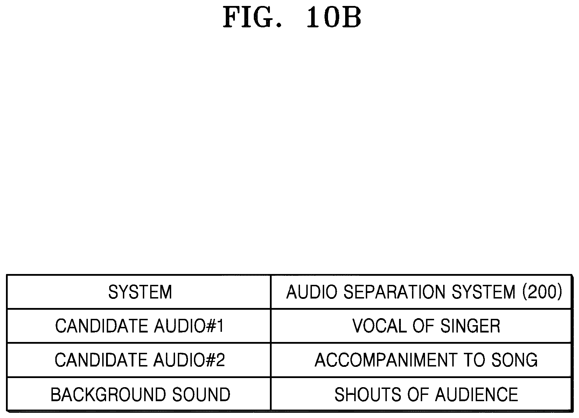

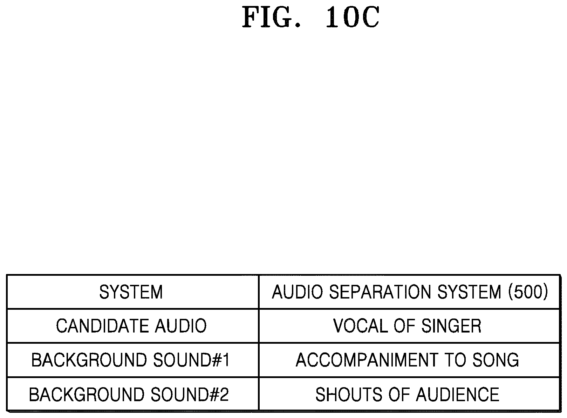

FIGS. 9a, 9b, 10a, 10b, and 10c are diagrams for describing application examples of the audio separation system 200 or 500 according to an embodiment of the disclosure.

FIG. 9a illustrates a scene of a video captured by an electronic device (e.g., smart phone or a tablet) including a camera. It is assumed that not only a voice of a person 911 appearing in the video, but also a voice of a cameraman 912 not appearing in the video, such as "I'm filming", and ambient noise such as voices of other people around the person 911, are recorded in the video. The audio separation system 200 may be used to separate the voice of the person 911 and the voice of the cameraman 912 in the video while adjusting the volume of the ambient noise included in the separated voice.

As shown in FIG. 9b, the audio separation system 200 may separate the voice of the person 911 and the voice of the cameraman 912 from a sound source, by processing the voice of the person 911 and the voice of the cameraman 912 as candidate audios and processing the ambient noise as a background sound. Here, an image including the face of the person 911 and a pre-recorded voice of the cameraman 912 may be used as target information for the voice of the person 911 and the voice of the cameraman 912. A background sound control parameter $\alpha$ may be determined based on the volume of the ambient noise adjusted by a user through a volume adjustment interface 923.

In a case in which the user adjusts the volumes of the voice of the person 911, the voice of the cameraman 912, and the ambient noise through volume adjustment interfaces 921, 922, and 923, respectively, the volume of each sound may be individually adjusted.

FIG. 10a illustrates a scene of a video of live performance of a singer. It is assumed that the performance video contains a vocal of a singer 1010, an accompaniment to a song sung by the singer 1010, and shouts of an audience.

As shown in FIG. 10b, the audio separation system 200 may be used to separate the vocal of the singer 1010 and the accompaniment to the song in the performance video, and adjust the volume of the shouts of the audience to be included in a separated sound.

The audio separation system 200 may separate the vocal of the singer 1010 and the accompaniment to the song from the sound source by processing the vocal of the singer 1010 and the accompaniment to the song as candidate audios and processing the shouts of the audience as a background sound. Here, an image including the face of the singer 1010 and pre-recorded music may be used as target information for the vocal of the singer 1010 and the accompaniment to the song, respectively. A background sound control parameter $\alpha$ may be determined based on the volume of the shouts of the audience adjusted by the user through a volume adjustment interface 1023.

Meanwhile, as illustrated in FIG. 10c, the audio separation system 500 may be used to separate only the vocal of the singer 1010 in the performance video, and individually adjust the volumes of the accompaniment to the song and the shouts of the audience included in the separated sound.

The audio separation system 500 may separate the vocal of the singer 1010 from the sound source by processing the vocal of the singer 1010 as a candidate audio, processing the accompaniment to the song as a first background sound, and processing the shouts of the audience as a second background sound. Here, an image including the face of the singer 1010 may be used as target information for the vocal of the singer 1010. A background sound control parameter $\alpha$ may be determined based on the volume of the accompaniment to the song adjusted by the user through a volume adjustment interface 1022, and a background sound control parameter $\beta$ may be determined based on the volume of the accompaniment to the song adjusted by the user through a volume adjustment interface 1023.

In a case in which the user adjusts the volumes of the vocal of the singer 1010, the accompaniment to the song, and the shouts of the audience through volume adjustment interfaces 1021, 1022, and 1023, respectively, the volume of each sound may be individually adjusted.

According to an embodiment of the disclosure, a method of separating one or more candidate audios in a sound source including the one or more candidate audios and a background sound, by using an audio separation system, includes extracting a first audio feature from the sound source, extracting a background sound feature from the sound source, the background sound feature identifying a degree of association between the first audio feature and the background sound, generating a second audio feature based on the first audio feature, the background sound feature, and a background sound control parameter configured to control the background sound and generating one or more separated audios based on target information corresponding to the one or more candidate audios, the first audio feature, and the second audio feature in which the background sound is adjusted.

In an embodiment, the extracting the first audio feature from the sound source may include generating a spectrogram of the sound source by applying a short-time Fourier transform (STFT) on the sound source, and processing the spectrogram of the sound source by using an audio feature extraction module including a plurality of convolution blocks, to extract the first audio feature from the sound source.

In an embodiment, the extracting the background sound feature from the sound source may include generating a spectrogram of the sound source by applying a short-time Fourier transform (STFT) on the sound source, and processing the spectrogram of the sound source by using a background sound analysis module including a plurality of convolution blocks, to extract the background sound feature from the sound source.

In an embodiment, the method may include obtaining a scaling factor based on the background sound control parameter and the background sound feature, and generating the second audio feature by scaling the first audio feature by using the scaling factor.

In an embodiment, the obtaining the scaling factor based on the background sound control parameter and the background sound feature may include based on the background sound control **parameter** being 1, obtaining the scaling factor to be 1, based on the background sound control parameter being 0, obtaining the scaling factor to be a smaller number as a size of the background sound feature increases, and obtaining the scaling factor to be a larger number as the size of the background sound feature decreases, wherein the scaling factor is greater than 0 but less than or equal to 1.

In an embodiment, the obtaining the scaling factor based on the background sound control parameter and the background sound feature may include obtaining the scaling factor according a background sound control function f(x) that is symmetric with respect to x = 0, approaches 0 as an absolute value of x increases, and satisfies f(0) = 1.

The background sound control function is

$$f(x) = \frac{4e^{-x}}{(1+e^{-x})^2}.$$

In an embodiment, the obtaining the scaling factor based on the background sound control parameter and the background sound feature comprises: obtaining the scaling factor according to $f\left(h_i^c \times (1-\alpha)\right)$, wherein $\alpha$ is the background sound control parameter and $h_i^c$ is the background sound feature.

In an embodiment, the method includes extracting a target feature from the target information corresponding to the one or more candidate audios by using a target feature extraction module, processing the target feature, the first audio feature, and the second audio feature by using an audio generation module including a plurality of up-convolution blocks, to generate spectrograms of the one or more separated audios, and generating the one or more separated audios by applying an inverse STFT (ISTFT) on the spectrograms of the one or more separated audios.

In an embodiment, the audio separation system may be trained by comparing an audio separation result inferred by the audio separation system with a target result, with respect to a training sound source comprising one or more training candidate audios and a training background sound. The training may be performed for a plurality of cases corresponding to a plurality of background sound parameters, and a separate target result may be used for each case.

In an embodiment, the extracting the background sound feature from the sound source may comprise: extracting a first background sound feature from the sound source; and extracting a second background sound feature from the sound source.

In an embodiment, the generating the second audio feature based on the first audio feature may comprise: obtaining the scaling factor based on a first background sound control parameter, a second background sound control parameter, the first background sound feature, and the second background sound feature and generating the second audio feature in which the background sound is adjusted, by scaling the first audio feature by using the scaling factor.

In an embodiment, the obtaining the scaling factor based on the first background sound control parameter, the second background sound control parameter, the first background sound feature, and the second background sound feature comprises obtaining the scaling factor according to $f\left(h_i^{c1} \times (1-\alpha)\right) \times f\left(h_i^{c2} \times (1-\beta)\right)$, wherein

$\alpha$ is the first background sound control parameter, $\beta$ is the second background sound control parameter, $h_i^{c1}$ is the first background sound feature, and $h_i^{c2}$ is the first background sound feature.

In an embodiment, the target information corresponding to the one or more candidate audios may be one of visual information or audio information that is separate from the one or more candidate audios.

In an embodiment, each of the one or more candidate audios may be a human voice, or a sound produced by a musical instrument or a machine. The background sound may include at least one of a human voice, ambient noise, or background music.

According to an embodiment, a computer-readable recording medium having recorded thereon a computer program that, when executed by one or more computing devices, may cause the one or more computing devices to perform a method of separating, by using an audio separation system, one or more candidate audios in a sound source including the one or more candidate audios and a background sound, the method including: extracting a first audio feature from the sound source, extracting a background sound feature from the sound source, the background sound feature identifying a degree of association between the first audio feature and the background sound, generating a second audio feature based on the first audio feature, the background sound feature, and a background sound control parameter configured to control the background sound and generating one or more separated audios based on target information corresponding to the one or more candidate audios, the first audio feature, and the second audio feature in which the background sound is adjusted.

According to an embodiment, an electronic device may include one or more processors and a memory storing a program for separating, by using an audio separation system one or more candidate audios in a sound source comprising the one or more candidate audios and a background sound. The program, when executed by the one or more processors, may cause the electronic device to perform operations including: extracting a first audio feature from the sound source, extracting a background sound feature from the sound source, the background sound feature identifying a degree of association between the first audio feature and the background sound, generating a second audio feature based on the first audio feature, the background sound feature, and a background sound control parameter configured to control the background sound and generating one or more separated audios based on target information corresponding to the one or more candidate audios, the first audio feature, and the second audio feature in which the background sound is adjusted.

## Claims

1. A method of separating, by using an audio separation system, one or more candidate audios in a sound source including the one or more candidate audios and a background sound, the method comprising:

   extracting a first audio feature from the sound source;
   extracting a background sound feature from the sound source, the background sound feature identifying a degree of association between the first audio feature and the background sound;
   generating a second audio feature based on the first audio feature, the background sound feature, and a background sound control parameter configured to control the background sound; and
   generating one or more separated audios based on target information corresponding to the one or more candidate audios, the first audio feature, and the second audio feature in which the background sound is adjusted.

2. The method of claim 1, wherein the extracting the first audio feature from the sound source comprises:

   generating a spectrogram of the sound source by applying a short-time Fourier transform (STFT) on the sound source, and
   processing the spectrogram of the sound source by using an audio feature extraction module including a plurality of convolution blocks, to extract the first audio feature from the sound source.

3. The method of claim 1 or 2, wherein the extracting the background sound feature from the sound source comprises:

   generating a spectrogram of the sound source by applying a short-time Fourier transform (STFT) on the sound source, and
   processing the spectrogram of the sound source by using a background sound analysis module including a plurality of convolution blocks, to extract the background sound feature from the sound source.

4. The method of any one of claims 1 to 3, further comprises:

   obtaining a scaling factor based on the background sound control parameter and the background sound feature, and
   generating the second audio feature by scaling the first audio feature by using the scaling factor.

5. The method of any one of claims 1 to 4, wherein the obtaining the scaling factor based on the background sound control parameter and the background sound feature comprises:

based on the background sound control parameter being 1, obtaining the scaling factor to be 1,
based on the background sound control parameter being 0, obtaining the scaling factor to be a smaller number as a size of the background sound feature increases, and obtaining the scaling factor to be a larger number as the size of the background sound feature decreases, and
wherein the scaling factor is greater than 0 but less than or equal to 1.

**6.** The method of any one of claims 1 to 5, wherein the obtaining the scaling factor based on the background sound control parameter and the background sound feature comprises:
obtaining the scaling factor according a background sound control function f(x) that is symmetric with respect to x = 0, approaches 0 as an absolute value of x increases, and satisfies f(0) = 1.

**7.** The method of any one of claims 1 to 6, wherein the obtaining the scaling factor based on the background sound control parameter and the background sound feature comprises:

obtaining the scaling factor according to

$$f\left(h_i^c \times (1-\alpha)\right),$$

wherein $\alpha$ is the background sound control parameter and $h_i^c$ is the background sound feature.

**8.** The method of any one of claims 1 to 7, further comprises:

extracting a target feature from the target information corresponding to the one or more candidate audios by using a target feature extraction module,
processing the target feature, the first audio feature, and the second audio feature by using an audio generation module including a plurality of up-convolution blocks, to generate spectrograms of the one or more separated audios, and generating the one or more separated audios by applying an inverse STFT (ISTFT) on the spectrograms of the one or more separated audios.

**9.** The method of any one of claims 1 to 8, wherein the audio separation system is trained by comparing an audio separation result inferred by the audio separation system with a target result, with respect to a training sound source comprising one or more training candidate audios and a training background sound,

wherein the training is performed for a plurality of cases corresponding to a plurality of background sound parameters, and
wherein a separate target result is used for each case.

**10.** The method of any one of claims 1 to 9, wherein the extracting the background sound feature from the sound source comprises: extracting a first background sound feature from the sound source; and extracting a second background sound feature from the sound source; and
wherein the generating the second audio feature based on the first audio feature comprises: obtaining the scaling factor based on a first background sound control parameter, a second background sound control parameter, the first background sound feature, and the second background sound feature; and generating the second audio feature in which the background sound is adjusted, by scaling the first audio feature by using the scaling factor.

**11.** The method of any one of claims 1 to 10, wherein the obtaining the scaling factor based on the first background sound control parameter, the second background sound control parameter, the first background sound feature, and the second background sound feature comprises:

obtaining the scaling factor according to

$$f\left(h_i^{c1} \times (1-\alpha)\right) \times f\left(h_i^{c2} \times (1-\beta)\right),$$

wherein $\alpha$ is the first background sound control parameter, $\beta$ is the second background sound control parameter, $h_i^{c1}$ is the first background sound feature, and $h_i^{c2}$ is the first background sound feature.

**12.** The method of any one of claims 1 to 11, wherein the target information corresponding to the one or more candidate audios is one of visual information or audio information that is separate from the one or more candidate audios.

**13.** The method of any one of claims 1 to 12, wherein each of the one or more candidate audios is a human voice, or a sound produced by a musical instrument or a machine, and
wherein the background sound comprises at least one of a human voice, ambient noise, or background music.

**14.** A computer-readable recording medium having recorded thereon a computer program that, when executed by one or more computing devices, causes the one or more computing devices to perform the method of any one of claims 1 to 13.

**15.** An electronic device (800) comprising:

one or more processors (840); and
a memory (850) storing a program for separating, by using an audio separation system one or more candidate audios in a sound source comprising the one or more candidate audios and a background sound,
wherein the program, when executed by the one or more processors (840), causes the electronic device (800) to perform operations comprising:

extracting a first audio feature from the sound source;
extracting a background sound feature from the sound source, the background sound feature identifying a degree of association between the first audio feature and the background sound;
generating a second audio feature based on the first audio feature, the background sound feature, and a background sound control parameter configured to control the background sound; and
generating one or more separated audios based on target information corresponding to the one or more candidate audios, the first audio feature, and the second audio feature in which the background sound is adjusted.

FIG. 1

# FIG. 2

# FIG. 3A

# FIG. 3B

$$f(x) = \frac{4e^{-x}}{(1 + e^{-x})^2}$$

FIG. 4

# FIG. 5

# FIG. 6

510

··· | Conv Block | ···

550

··· | UP-Conv Block | ···

$h_i$

$h_i'$

530

$$\alpha, \beta \dashrightarrow \quad h_i' = f\!\left(h_i^{c1} \times (1 - \alpha)\right) \times f\left(h_i^{c2} \times (1 - \beta)\right) \times h_i$$

$h_i^{c1}$

$h_i^{c2}$

··· | Conv Block | ···

··· | Conv Block | ···

520A

520B

# FIG. 7

700

START

EXTRACT FIRST AUDIO FEATURE FROM SOUND SOURCE — 710

EXTRACT BACKGROUND SOUND
FEATURE FROM SOUND SOURCE — 720

GENERATE A SECOND AUDIO FEATURE BASED ON THE
FIRST AUDIO FEATURE, THE BACKGROUND SOUND FEATURE,
AND A BACKGROUND SOUND CONTROL PARAMETER — 730
CONFIGURED TO CONTROL THE BACKGROUND SOUND

GENERATE ONE OR MORE SEPARATED AUDIOS BASED ON
TARGET INFORMATION CORRESPONDING TO THE ONE
OR MORE CANDIDATE AUDIOS, THE FIRST AUDIO FEATURE, — 740
AND THE SECOND AUDIO FEATURE IN WHICH
BACK GROUND SOUND IS ADJUSTED

END

# FIG. 8

# FIG. 9A

# FIG. 9B

| SYSTEM | AUDIO SEPARATION SYSTEM (200) |
|---|---|
| CANDIDATE AUDIO#1 | VOICE OF PERSON APPEARING IN VIDEO |
| CANDIDATE AUDIO#2 | VOICE OF CAMERAMAN |
| BACKGROUND SOUND | AMBIENT NOISE |

# FIG. 10A

# FIG. 10B

| SYSTEM | AUDIO SEPARATION SYSTEM (200) |
|---|---|
| CANDIDATE AUDIO#1 | VOCAL OF SINGER |
| CANDIDATE AUDIO#2 | ACCOMPANIMENT TO SONG |
| BACKGROUND SOUND | SHOUTS OF AUDIENCE |

# FIG. 10C

| SYSTEM | AUDIO SEPARATION SYSTEM (500) |
|---|---|
| CANDIDATE AUDIO | VOCAL OF SINGER |
| BACKGROUND SOUND#1 | ACCOMPANIMENT TO SONG |
| BACKGROUND SOUND#2 | SHOUTS OF AUDIENCE |

## INTERNATIONAL SEARCH REPORT

| International application No. |
| --- |
| **PCT/KR2024/001134** |

| | |
| --- | --- |
| **A.** | **CLASSIFICATION OF SUBJECT MATTER** |

**G10L 21/0272**(2013.01)i; **G10L 21/0208**(2013.01)i; **G10L 25/18**(2013.01)i; **G10L 25/24**(2013.01)i; **G10L 25/81**(2013.01)i; **G10L 21/0332**(2013.01)i

According to International Patent Classification (IPC) or to both national classification and IPC

| | |
| --- | --- |
| **B.** | **FIELDS SEARCHED** |

Minimum documentation searched (classification system followed by classification symbols)

G10L 21/0272(2013.01); A61B 5/00(2006.01); A61B 5/025(2006.01); G06N 99/00(2010.01); G10L 15/04(2006.01); G10L 15/10(2006.01); G10L 21/043(2013.01); H04N 5/91(2006.01); H04R 1/10(2006.01); H04R 3/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 오디오(audio), 분리(separation), 배경음(background sound), 특징(feature), 연관성 (correlation), 단시간 푸리에 변환(Shorttime Fourier Transform), 스펙트로그램(spectrogram), 스케일링(scaling), 소음(noise)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| X | KR 10-2008-0069400 A (SAMSUNG ELECTRONICS CO., LTD.) 28 July 2008 (2008-07-28) See paragraphs [0010] and [0017]; and figures 1-3 and 5. | 1,4,10,12-15 |
| Y | | 2-3,8-9 |
| A | | 5-7,11 |
| Y | JP 2015-031889 A (HANDOTAI RIKOUGAKU KENKYU CT.) 16 February 2015 (2015-02-16) See paragraphs [0017], [0022], [0038] and [0051]. | 2-3,8-9 |
| A | JP 2000-092435 A (MATSUSHITA ELECTRIC IND. CO., LTD.) 31 March 2000 (2000-03-31) See claims 1-18. | 1-15 |
| A | JP 2015-184349 A (JAPAN BROADCASTING CORP. et al.) 22 October 2015 (2015-10-22) See claims 1-7. | 1-15 |

| ✓ Further documents are listed in the continuation of Box C. | ✓ See patent family annex. |
| --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **26 April 2024** | **26 April 2024** |

| Name and mailing address of the ISA/KR | Authorized officer |
| --- | --- |
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2024/001134** |

| C. | DOCUMENTS CONSIDERED TO BE RELEVANT | |
|---|---|---|
| Category* | Citation of document, with indication, where appropriate, of the relevant passages | Relevant to claim No. |
| A | KR 10-2018-0119446 A (INDUSTRY-ACADEMIC COOPERATION FOUNDATION, YONSEI UNIVERSITY) 02 November 2018 (2018-11-02)<br>See claims 1-8. | 1-15 |

Form PCT/ISA/210 (second sheet) (July 2022)

## INTERNATIONAL SEARCH REPORT
### Information on patent family members

International application No.

**PCT/KR2024/001134**

| Patent document cited in search report | | | Publication date (day/month/year) | Patent family member(s) | | | Publication date (day/month/year) |
|---|---|---|---|---|---|---|---|
| KR | 10-2008-0069400 | A | 28 July 2008 | US | 2008-0175399 | A1 | 24 July 2008 |
| | | | | US | 2014-0321654 | A1 | 30 October 2014 |
| | | | | US | 8792648 | B2 | 29 July 2014 |
| | | | | US | 9748913 | B2 | 29 August 2017 |
| JP | 2015-031889 | A | 16 February 2015 | None | | | |
| JP | 2000-092435 | A | 31 March 2000 | None | | | |
| JP | 2015-184349 | A | 22 October 2015 | JP | 6313619 | B2 | 18 April 2018 |
| KR | 10-2018-0119446 | A | 02 November 2018 | None | | | |

Form PCT/ISA/210 (patent family annex) (July 2022)